Europäisches Patentamt

European Patent Office

Office européen des brevets

(19)

(11) Veröffentlichungsnummer: **0 166 475**
**B1**

(12) **EUROPÄISCHE PATENTSCHRIFT**

(45) Veröffentlichungstag der Patentschrift: **02.01.91**

(51) Int. Cl.⁵: **H 05 K 7/18, H 05 K 7/14**

(21) Anmeldenummer: **85200817.6**

(22) Anmeldetag: **22.05.85**

(54) Geräteeinsatz für Gestelle der Nachrichtentechnik.

(30) Priorität: **26.05.84 DE 3419781**

(43) Veröffentlichungstag der Anmeldung:
**02.01.86 Patentblatt 86/01**

(45) Bekanntmachung des Hinweises auf die
Patenterteilung:
**02.01.91 Patentblatt 91/01**

(84) Benannte Vertragsstaaten:
**DE FR GB IT SE**

(56) Entgegenhaltungen:
**EP-A-0 097 228**
**DE-A-2 002 350**
**DE-B-2 115 404**
**DE-C-1 262 383**

(73) Patentinhaber: **Philips Patentverwaltung GmbH
Wendenstrasse 35 Postfach 10 51 49
D-2000 Hamburg 1 (DE)**
(84) **DE**

(73) Patentinhaber: **N.V. Philips'
Gloeilampenfabrieken
Groenewoudseweg 1
NL-5621 BA Eindhoven (NL)**
(84) **FR GB IT SE**

(72) Erfinder: **Felsner, Fritz
Altdorferstrasse 12
D-8566 Leinburg (DE)**
Erfinder: **Geier, Erich
Lindenstrasse 7
D-8504 Stein (DE)**

(74) Vertreter: **Peuckert, Hermann, Dipl.-Ing. et al
Philips Patentverwaltung GmbH Wendenstrasse
35 Postfach 10 51 49
D-2000 Hamburg 1 (DE)**

Courier Press, Leamington Spa, England.

EP 0 166 475 B1

**Beschreibung**

Die Erfindung betrifft einen in Gestelle der Nachrichtentechnik einsetzbaren Geräteeinsatz.

Neuer Beschreibungsteil Einzufügen auf Seite 1 nach Zeile 6

In DE-B 21 15 404 ist eine Aufnahmevorrichtung für Geräteeinheiten der elektrischen Nachrichtenübertragungstechnik beschrieben, bei der an zwei L-förmigen, in spiegelbildlicher Lage befindlichen Winkelschienen im Abstand der vertikalen Abmessungen der Geräteeinheiten übereinander konsolartig ausgebildete Einhängevorrichtungen angebracht sind. An deren inneren Ober- bzw. Innenseiten sind Führungsschienen sowie Befestigungsvorrichtungen zur Befestigung der Geräteeinheiten vorgesehen, die an der Ober- bzw. Unterseite der Geräteeinheiten angebrachten Führungsschienen entsprechen. Die einsetzbaren Geräteeinheiten sind mittels an ihrer Rückseite angebrachter Steckverbinderteile mit zwischen den L-Schienen angeordneten Gegensteckverbindermitteln verbindbar. An der Unterseite der konsolartig ausgebildeten Einhängevorrichtung ist ein hakenförmiger Schwenkhebel mit einer Kulissenführung gelagert, so daß er sich zwischen der Oberseite der einsetzbaren Geräteeinheit und der Unterseite der konsolartig ausgebildeten Tragvorrichtung befindet, wenn die Geräteeinheit eingeschoben ist. Beim Einschieben der Geräteeinheit in die Aufnahmevorrichtung wird durch Betätigen des Schwenkhebels ein an der Oberseite der Geräteeinheit befindlicher Zapfen erfaßt, wodurch mittels der Kulissenführung die Geräteeinheit in die Einhängevorrichtung hineingeschoben wird.

Die DE-C 12 62 383 betrifft einen Schnellverschluß mit Auszieh und Eindrückvorrichtung für in Gestellanordnungen der elektrischen Übertragungstechnik einsetzbare, insbesondere schwenkbar angeordnete Geräteeinheiten mit auf ihrer Rückseite vorhandenen Mehrfachsteckverbindungen. Die einsetzbaren Geräteeinheiten tragen einen auf beiden Außenseiten einer Geräteeinheit gelagerten schwenkbaren Bügel, dessen Seitenteile an ihrem freien Ende durch einen Quersteg miteinander verbunden sind und der an seinen Enden scheibenförmig ausgebildet und derart mit einer hakenförmigen Ausbildung versehen ist, daß Spiralschlitze gebildet werden. An entsprechender Stelle der Gestellanordnung selbst sind Zapfen angebracht, die in die Spiralschlitze eingreifen, so daß je nach Bewegungsrichtung des Bügels eine die Kontakte ineinander schiebende oder lösende Wirkung erzielbar ist.

Unter der Bezeichnung Bauweise 7R ist eine Gestellbauweise für die Nachrichtentechnik bekannt geworden, bei der in Gestellreihen mit Schmalgestellen vertikal längsgestreckte Geräteeinsätze übereinander einsetzbar sind. Aufnahme der Geräteeinsätze ist ein Gestellrahmen vorgesehen, welcher aus einem Kopfrahmen, einem Sockel, zwei Profilschienen sowie einem Anschlußrahmen und Halteschienen zum Einhängen der Geräteeinsätze besteht. In den Seitenwänden der Geräteeinsätze befinden sich in einem bestimmten Rastermaß vertikal übereinander kurze horizontale Schlitze. In diese können bei Bedarf Führungsschienen für vertikal übereinander anzuordnende Einschübe eingeschnappt werden.

Die Geräteeinsätze sind auch zur Aufnahme von Einschüben geeignet, die ebenfalls als vertikal langgestreckte schmale Einheiten (Vertikaleinschübe) ausgebildet sein können, so daß mindestens zwei solcher Vertikaleinschübe nebeneinander in einem Geräteeinsatz unterzubringen sind. An ihren rückwärtigen Seiten tragen sie Steckverbinder, mit denen sie in Gegensteckvorrichtungen des Geräteeinsatzes eingreifen. Die Vertikaleinschübe sind mit Schrauben oben und unten im Geräteeinsatz befestigt.

Beim Entnehmen eines Vertikaleinschubes müssen auch die Steckkräfte überwunden werden, die wegen der oft hohen Anzahl von Steckverbindungen erhebliche Werte annehmen können. Dies hat zur Folge, daß sich ein Vertikaleinschub nach Überwindung der Steckkräfte rukkartig löst, wodurch eine unkontrollierte Bewegung des Vertikaleinschubes im Geräteeinsatz ausgelöst wird und Beschädigungen hervorgerufen werden können. Deshalb können die Befestigungsschrauben im Vertikaleinschub so gehalten sein, daß sie beim Lösen des Vertikaleinschubes gleichzeitig als Zugschrauben gegen die Richtung der Steckkräfte wirken. Es können auch besondere Zugschrauben vorgesehen sein. Die Schrauben müssen beim Entnehmen eines Vertikaleinschubes in einer vorgeschriebenen Reihenfolge betätigt werden, damit ein Verkanten vermieden wird. Die Betätigung dieser Schrauben ist zeitraubend, außerdem ist leicht eine Fehlbedienung möglich, so daß ein Verkanten des Vertikaleinschubes in seiner Führung im Geräteeinsatz auftritt und die Führungen und die Steckverbinder beschädigt werden können.

Der Erfindung liegt die Aufgabe zugrunde, den Geräteeinsatz der vorbeschriebenen Art derart zu verbessern, daß nach dem Lösen eventuell vorhandener Befestigungsschrauben ohne Einhalten einer vorgegebenen Reihenfolge ein Vertikaleinschub ohne besonderen Kraftaufwand möglichst ruckfrei entnommen werden kann und Verkantungen vermieden werden.

Diese Aufgabe wird gemäß der Erfindung bei einer Einrichtung der obenbeschriebenen Art dadurch gelöst,

daß zwischen einem Vertikaleinschub und einer Seitenwand des Geräteeinsatzes ein an einer in einem Schlitz der Seitenwand befestigten Drehachse gehaltener von der Frontseite des Geräteeinsatzes betätigbarer Hebel geführt ist, der mit einem Betätigungsansatz am Ende gegen die Rückwand des Vertikaleinschubes greift.

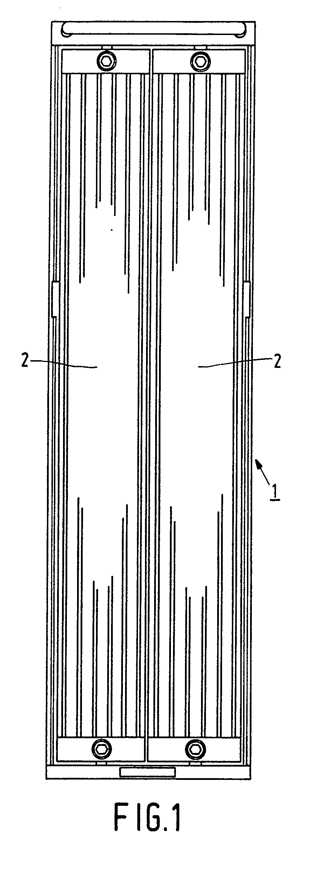

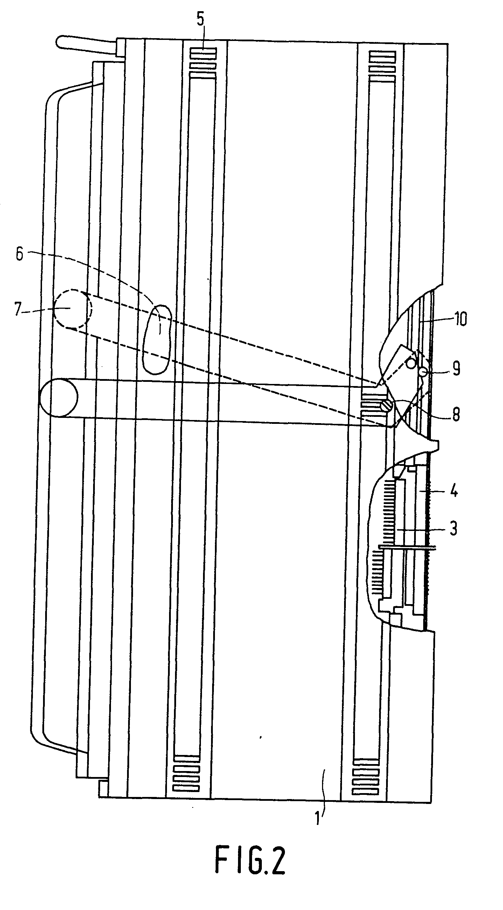

Im folgenden soll die Erfindung anhand eines in den Figuren 1 und 2 dargestellten Ausführungsbeispiels näher beschrieben und erläutert werden.

Fig. 1 zeigt einen Geräteeinsatz von der Vorderseite.

Fig. 2 zeigt einen Geräteeinsatz von der Seite.

Der in Fig. 1 gezeigte Geräteeinsatz 1 für Schmalgestelle der Nachrichtentechnik enthält zwei Vertikaleinschübe 2, die in diesem Geräteeinsatz nebeneinander eingesteckt sind. An ihrer Vorderseite tragen sie Kühlkörper, mit denen die von den Bauelementen im Inneren der Vertikaleinschübe abgegebene Verlustwärme an die Außenluft abgeführt wird. Die Vertikaleinschübe sind im Geräteeinsatz oben und unten in Führungsschienen geführt.

In Fig. 2 ist der Geräteeinsatz von der Seite gezeigt. An der Rückseite der Vertikaleinschübe sind Steckverbinder 3 angebracht, die in Gegensteckvorrichtungen 4 an der Innenseite des Geräteeinsatzes eingreifen. Die Verbindungseinrichtungen zur Verbindung des Geräteeinsatzes mit dem Gestell sind zur Vereinfachung der Darstellung nicht eingezeichnet.

Die Seitenwände des Geräteeinsatzes weisen vertikal übereinander horizontale Schlitze 5 auf. Zur Erleichterung des Herausziehens eines Vertikaleinschubes 2 ist zwischen dem Vertikaleinschub und der Seitenwand des Geräteeinsatzes 1 ein flacher Hebel 6 vorgesehen, dessen Betätigungsgriff 7 nach vorn aus dem Geräteeinsatz herausragt. Seine Drehachse 8 ist eine Schraube, die in einem Schlitz der Seitenwand gehalten ist. Die Schraube kann zwischen ihrem Kopf und dem Gewinde noch einen Bund aufweisen, dessen Durchmesser größer ist als die Schlitzbreite, so daß die Schraube im Schlitz festgezogen werden kann und der Hebel mit dem Bund als Lager frei beweglich ist. Die Achse des Hebels kann aber auch lose im Schlitz sitzen, wobei dann das Ende des Schlitzes als Anschlag dient. Sie kann dann als ein am Hebel befestigter Zapfen ausgebildet sein, der in der Seitenwand mit einer Federscheibe gesichert ist.

Mit einem Betätigungsansatz an seinem Ende 9 greift der Hebel gegen die Rückwand 10 des Einsachubes, so daß beim Niederdrücken des Betätigungsgriffes 7 die Steckverbinder des Vertikaleinschubs 2 aus ihren Gegenteckvorrichtungen 4 im Geräteeinsatz leicht und ruckfrei herausgezogen werden können. Der Betätigungsansatz ist ein runder Zapfen, der mit dem Hebelende verschweißt ist. Eine vorteilhafte Ausgestaltung besteht darin, daß über den Zapfen ein Rohrstück gesteckt ist, welcher gegenüber dem Zapfen beweglich ist. Hierdurch wird die Reibung gegenüber der Rückwand des Vertikaleinschubes weiter vermindert.

Infolge der unterschiedlichen Ausbildung der Vertikaleinschübe entsprechend ihrem jeweiligen Zweck können die Steckverbinder an den Rückseiten unterschiedlich verteilt sein, wodurch siech auch eine unterschiedliche Verteilung der Steckkräfte ergibt und jeder Vertikaleinschubtyp einen anderen Kräfteschwerpunkt hat. Die Erfindung hat den Vorteil, daß diesem Umstand in einfacher Weise dadurch Rechnung getragen werden kann, daß je nach dem Kräfteschwerpunkt zur Befestigung des Hebels ein bestimmter Schlitz aus der vertikalen Schlitzreihe ausgewählt wird. Ein weiterer Vorteil besteht darin, daß der Hebel auch bei bereits in Betrieb befindlichen Einrichtungen der eingangs beschriebenen Art ohne Veränderungen an diesen Einrichtungen leicht nachgerüstet werden kann.

## Patentansprüche

1. Geräteeinsatz für Gestelle der Nachrichtentechnik zur Aufnahme von Vertikaleinschüben, dadurch gekennzeichnet, daß der Geräteeinsatz an seinen Seitenwänden vertikal übereinander angeordneten horizontalen Schlitzen, aufweist, daß zwischen einem Vertikaleinschub (2) und einer Seitenwand des Geräteeinsatzes (1) ein an einer in einem Schlitz (5) der Seitenwand befestigten Drehachse gehaltener von der Frontseite des Geräteeinsatzes betätigbarer Hebel (6) geführt ist, der mit einem Betätigungsansatz am Ende (9) gegen die Rückwand des Vertikaleinschubes greift.

2. Geräteeinsatz nach Anspruch 1, dadurch gekennzeichnet, daß die Drehachse eine Schraube (8) ist.

3. Geräteeinschub nach einem der Ansprüche 1 bis 2, dadurch gekennzeichnet, daß der Betätigungsansatz am Ende (9) des Hebels (6) ein runder Zapfen ist.

## Revendications

1. Pièce d'insertion pour bâtis de télécommunication destinée à recevoir des tiroirs verticaux, caractérisée en ce qu'elle présente, dans ses parois latérales, des fentes horizontales disposées verticalement les unes au-dessus des autres, et en ce qu'entre un tiroir vertical (2) et une paroi latérale de la pièce d'insertion (1) est guidé un levier (6) qui est maintenu sur un axe de pivotement fixé dans une des fentes (5) de la paroi latérale et qui peut être actionné à partir de la face avant de la pièce d'insertion, ce levier attaquant la paroi postérieure du tiroir vertical par l'intermédiaire d'une saillie d'actionnement prévue à son extrémité (9).

2. Pièce d'insertion suivant la revendication 1, caractérisée en ce que l'axe de pivotement est une vis (8).

3. Pièce d'insertion suivant la revendication 1 ou 2, caractérisé en ce que la saillie d'actionnement, à l'extrémité (9) du levier (6), est un tourillon rond.

## Claims

1. An insertion unit which can be inserted into a telecommunication frame for the accommodation of vertical insertion circuit boards, characterized in that the insertion unit (1) has on its side walls horizontal slots which are arranged vertically one above the other, and in that a lever (6), which can be operated from the front of the insertion unit and which is attached to a rotation spindle mounted in a slot (5) in a side wall of the insertion unit, is guided between a vertical insertion circuit board (2) and this side wall, which lever bears with an actuating stub at its end (9) on the rear wall of the vertical insertion circuit board.

2. An insertion unit as claimed in Claim 1, characterized in that the fulcrum is a screw (8).

3. An insertion unit as claimed in any one of the Claims 1 and 2, characterized in that the actuating stub at the end (9) of the lever (6) is a round plug.

FIG.1

FIG.2